# EUROPÄISCHE PATENTANMELDUNG

(11) **EP 3 627 612 A1**
(43) Veröffentlichungstag der Anmeldung: **25.03.2020**
(21) Anmeldenummer: 18195799.4
(22) Anmeldetag: 20.09.2018
(51) Int. Cl.: H01M 10/42, H01M 2/02, G01R 31/00

(54) **VORRICHTUNG ZUR PRÜFUNG EINER ISOLATIONSSCHICHT**

(71) Anmelder: Berghof Automation GmbH, 99974 Mühlhausen (DE)
(72) Erfinder: MISKA, Philipp, 99998 Mühlhausen (DE); WERNEBURG, Daniel, 99986 Oppershausen (DE); SCHOLLENBERGER, Gerd, 72800 Eningen (DE)
(74) Vertreter: Forstmeyer, Dietmar

(57) **Zusammenfassung**

Die vorliegende Erfindung betrifft eine Vorrichtung zur Prüfung einer Isolationsschicht (insbesondere einer Isolationsschicht einer Batteriezelle mit metallischem Gehäuse) durch Anlegen einer Hochspannung, die dadurch gekennzeichnet ist, dass die Vorrichtung eine elektrisch leitfähige PTFE Folie umfasst.

## Beschreibung

Die vorliegende Erfindung betrifft eine Vorrichtung zur Prüfung einer Isolationsschicht (insbesondere einer Lackschicht), insbesondere von Batteriezellen (z. B. von Lithium-Ionen-Batteriezellen oder Lithium-Zellen).

In der Praxis sind Lithium-Ionen-Batteriezellen in einem Batteriezellengehäuse mit einem metallischen Anteil angeordnet. Solche Batteriezellengehäuse können beispielsweise zu einem Großteil aus tiefgezogenem Aluminium-Blech bestehen. Man spricht hier auch von einem sogenannten Hartschalen-Gehäuse oder einem Hardcase. Beispielsweise existieren im Stand der Technik Lithium-Ionen-Batteriezellen, welche ein solches, meist prismatisch geformtes Hardcase-Gehäuse aufweisen. Daneben existieren beispielsweise auch Lithium-Ionen-Batteriezellen mit einem zylindrischen Hardcase-Gehäuse. Solche, auch Rundzellen genannte Batteriezellen kommen zum Beispiel in Handwerksgeräten zur Anwendung.

Die in einem solchen Hardcase-Batteriezellengehäuse angeordneten Batteriezellen sind aufgrund ihrer metallischen Oberfläche elektrisch leitend. Dies ist insbesondere bei der Nutzung der Batteriezelle in einem Batteriemodul problematisch. Beispielsweise die serielle Verschaltung von derartigen Batteriezellen ist insbesondere dann problematisch, wenn ein Potenzial einer inneren, positiven oder negativen Elektrode der Batteriezelle auf dem Potenzial des Batteriezellengehäuses liegt, also mit dem Batteriezellengehäuse elektrisch leitfähig verbunden ist. In einem solchen Fall können zwischen den seriell verschalteten Batteriezellen beziehungsweise den Batteriezellengehäusen der Batteriezellen des Batteriemoduls Spannungen durchschlagen, welche zu einer Beschädigung des Batteriemoduls führen und dieses unbrauchbar machen können.

Daher werden die Batteriezellen mit einer Isolierung versehen. Dabei werden neben Folien auch Beschichtungen (zum Beispiel eine Lackierung) eingesetzt, welche jedoch Fehlstellen und/oder Beschädigungen aufweisen können. Derartige Isolationslacke können beispielsweise auf der Basis von Polyurethan oder Epoxid hergestellt sein. Es besteht somit ein Interesse daran, die Unversehrtheit der Isolationsschicht (insbesondere einer Lackschicht) einer Batteriezelle (z.B. einer Lithium-Zelle) zu prüfen, vorzugsweise bereits während der Produktion. Die besonders kritischen Stellen einer Batteriezelle sind dabei die Kanten und die Ecken der Zelle.

Bei einer solchen Prüfung wird die Isolationsschicht der Batteriezelle mit einem elektrisch leitenden Material (Kontaktiermaterial) in Kontakt gebracht. Anschließend wird eine Hochspannung (HV) angelegt, d.h. eine elektrische Spannung über 1.000 Volt (1kV). Das metallische Gehäuse (z.B. das Aluminiumgehäuse) der Batteriezelle bildet dabei den Gegenpol für den Hochspannungstest. Wenn die Isolationsschicht zu dünn oder fehlerhaft ist, erfolgt bei einem solchen Hochspannungstest ein elektrischer Durchschlag.

Das Kontaktiermaterial sollte vorzugsweise die folgenden Eigenschaften aufweisen:
- Es muss elektrisch leitfähig sein;
- es sollte robust gegenüber Durchschlägen sein;
- es sollte flexibel sein;
- es sollte schonend für die Isolationsschicht sein, d.h. diese beim Kontaktieren nicht beschädigen;
- es sollte reversibel verformbar sein; und
- es sollte mechanisch belastbar und verschleißarm sein.

In analoger Weise kann auch die Unversehrtheit einer Isolationsschicht (insbesondere einer Lackschicht) von weiteren Gegenständen, die eine solche Isolationsschicht (insbesondere eine solche Lackschicht) aufweisen, geprüft werden, insbesondere von Gegenständen, bei denen eine elektrische Isolation über eine Fläche wichtig ist (z.B. zum Funktionstest, Geräte- oder Personenschutz). Beispiele für solche weiteren Gegenstände sind Kabel, Gehäuse von elektrischen Geräten jeder Art wie Industriekomponenten (z.B. Schaltschrankgehäuse), Haushaltselektronik (von der Waschmaschine bis zum Heizkessel), Unterhaltungselektronik und Automobil-Komponenten (z.B. von Zündkabel bis Lichtmaschine).

Es war die Aufgabe der vorliegenden Erfindung, eine Vorrichtung zur Prüfung einer Isolationsschicht (insbesondere einer Lackschicht), insbesondere von Batteriezellen (z.B. von Lithium-Ionen-Batteriezellen oder Lithium-Zellen) bereitzustellen.

Die vorliegende Erfindung betrifft eine Vorrichtung zur Prüfung einer Isolationsschicht, insbesondere einer Isolationsschicht einer Batteriezelle mit metallischem Gehäuse, die dadurch gekennzeichnet ist, dass die Vorrichtung eine elektrisch leitfähige PTFE Folie umfasst.

Ferner betrifft die vorliegende Erfindung die Verwendung einer elektrisch leitfähigen PTFE Folie zur Prüfung einer Isolationsschicht, insbesondere einer Isolationsschicht einer Batteriezelle mit metallischem Gehäuse.

Des Weiteren betrifft die vorliegende Erfindung ein Verfahren zur Prüfung einer Isolationsschicht, insbesondere einer Isolationsschicht einer Batteriezelle mit metallischem Gehäuse, durch Anlegen einer Hochspannung, das dadurch gekennzeichnet ist, dass eine elektrisch leitfähige PTFE Folie zur Kontaktierung der Isolationsschicht verwendet wird.

Erfindungsgemäß wird elektrisch leitfähiges PTFE (Polytetrafluorethylen) als Kontaktiermaterial verwendet, d.h. PTFE, das mit einem elektrisch leitfähigen Material (z.B. mit leitfähigen Partikeln) modifiziert bzw. versetzt ist.

Im Rahmen der vorliegenden Erfindung bezieht sich der Ausdruck "leitfähig" bzw. "leitend" auf die elektrische Leitfähigkeit. Vorzugsweise bezieht sich der Begriff "elektrisch leitfähig" auf eine Leitfähigkeit von >10⁻⁸ S/m; bevorzugt >10⁻⁶ S/m; insbesondere >10⁻³ S/m. Weiterhin bevorzugt beträgt der spezifische Flächenwiderstand der elektrisch leitfähigen PTFE Folie maximal 100 kOhm; vorzugsweise maximal 75 kOhm (z.B. ca. 50 kOhm).

Bevorzugt ist die erfindungsgemäß verwendete PTFE Folie porös.

Bei der erfindungsgemäß verwendeten PTFE (Polytetrafluorethylen) Folie handelt es sich vorzugsweise um eine HV-PTFE Folie (wie beispielsweise eine modifizierte Permeaflon Folie).

Die erfindungsgemäß bevorzugt verwendete leitfähige PTFE Folie enthält vorzugsweise reines, poröses PTFE, das mit einem elektrisch leitfähigen Material modifiziert ist, oder besteht daraus.

Eine bevorzugte erfindungsgemäß verwendete PTFE Folie ist in EP 2 857 438 A1 beschrieben.

Beispiele für elektrisch leitfähige Materialien die zur Modifikation des PTFE verwendet werden können sind: Rußpartikel, Grafit, Edelstahlfasern und Aluminiumpartikel.

Das erfindungsgemäß vorzugsweise eingesetzte PTFE zeichnet sich vorzugsweise durch folgende Eigenschaften aus:
- es ist elektrisch leitfähig;
- es ist HV-beständig;
- es besitzt hervorragende Gleiteigenschaften;
- es weist eine hohe Flammbeständigkeit auf;
- es ist formstabil;
- es ist temperaturbeständig im Bereich von -200°C bis 250°C;
- es ist chemisch hoch beständig; und
- es ist physiologisch unbedenklich.

Vorzugsweise wird eine PTFE Folie mit einer Stärke von 0.1 bis 1.0 mm, vorzugsweise mit einer Stärke von 0,2 bis 0,5 mm (z.B. mit einer Stärke von 0,3 bis 0.35 mm) verwendet.

Bevorzugt weist die erfindungsgemäße Vorrichtung eine oder mehrere (insbesondere mehrere) Flächen mit Kontaktiermaterial (Kontaktierflächen) auf, welche den zu prüfenden Gegenstand (z.B. die zu prüfende Batteriezelle) zumindest teilweise umschließen.

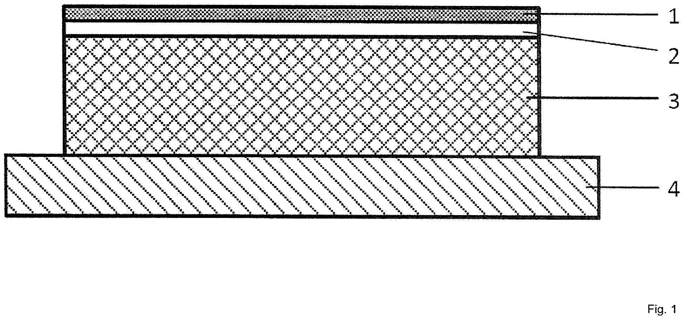

Vorzugsweise umfasst eine Kontaktierfläche eine elektrisch leitfähige PTFE Folie (1), die vorzugsweise mit einem elektrisch leitfähigen Klebefilm (2) auf einem Füllmaterial (insbesondere einem Schaumstoff) (3) aufgebracht ist, welches wiederum auf einem Trägermaterial (4) aufgebracht ist. In Fig. 1 ist ein Querschnitt einer solchen bevorzugten Kontaktierfläche gezeigt.

Der Schaumstoff fungiert bei der vorliegenden Erfindung als Kissen bzw. Polster und sorgt dafür, dass die PTFE Folie optimal an die Isolierschicht des zu prüfenden Gegenstands (z.B. der zu prüfenden Batteriezelle) gedrückt wird. Ferner gleicht der Schaumstoff Unebenheiten auf der Oberfläche des zu prüfenden Gegenstands aus, wodurch das Kontaktiermaterial ohne Zwischenräume an der zu prüfenden Isolierschicht anliegt.

Bei der vorliegenden Erfindung kann ein handelsüblicher Schaumstoff verwendet werden. Der Schaumstoff zeichnet sich vorzugsweise durch Flexibilität und Formstabilität aus. Vorzugsweise ist der Schaumstoff offenporig und dadurch nachgiebig. Besonders bevorzugt weist der Schaumstoff eine Stauchhärte bei 40% von weniger als 300 kPa, vorzugsweise von 1 bis 250 kPa, insbesondere von 5 bis 200 (z.B. etwa 135 kPa) auf.

Bevorzugte Materialien des erfindungsgemäß verwendeten Schaumstoffs sind Polyurethan (PU), Ethylen-Propylen-Dien-Kautschuk (EPDM) und Polyvinylchlorid (PVC); insbesondere PU.

Die Dicke der Schaumstoffschicht wird vorzugsweise so ausgewählt, dass sie ausreichend nachgeben kann, um Unebenheiten auf der Oberfläche des zu prüfenden Gegenstandes auszugleichen. Es ist beispielsweise bevorzugt, wenn die Schaumstoffschicht mindestens 1 mm nachgeben kann. Die Dicke der Schaumstoffschicht beträgt vorzugsweise von 3 bis 10 mm; insbesondere von 4 bis 7 mm (z.B. ca. 5 oder ca. 6 mm).

Vorzugsweise wird ein elektrisch leitfähiger Klebefilm aus einem Klebstoff mit elektrisch leitfähigen Partikeln und/oder Fasern verwendet. Der Klebstoff umfasst vorzugsweise ein Acrylat mit elektrisch leitfähigen Partikeln und/oder Fasern als Füllstoff. Ein elektrisch leitfähiger Klebefilm ist beispielsweise in WO 2018/022840 beschrieben.

Besonders bevorzugt wird als leitfähiger Klebefilm der dreidimensional (XYZ-Achse) elektrisch leitfähige Klebstoff-Film 9713 der Firma 3M verwendet. Bei diesem Klebstoff-Film handelt es sich um ein isotrop leitfähiges, druckempfindliches Klebeband. Es leitet den Strom durch die Dicke (z-Achse) und über die Fläche des Klebstoffs (x-, y-Ebenen).

Der leitfähige Klebefilm dient insbesondere der Optimierung der Leitfähigkeit. Durch die Verwendung eines leitfähigen Klebefilms wird der Gesamtwiderstand der Kontaktfläche deutlich reduziert. Daher ist der Punkt-zu-Punkt Widerstand über die gesamte Kontaktierfläche annähernd konstant.

Die Dicke des Klebefilms beträgt vorzugsweise 0,05 bis 0,15 mm.

Als Trägermaterial können Kunststoffe wie beispielsweise PLA (Polylactid), ABS (Acrylnitril-Butadien-Styrol-Copolymer), POM (Polyoxymethylen) oder FR4 verwendet werden.

Das Trägermaterial wird vorzugsweise so ausgebildet, dass es den zu prüfenden Gegenstand (z.B. die zu prüfende Batteriezelle) aufnehmen kann bzw. zumindest teilweise umschließt. Dabei wird das Trägermaterial vorzugsweise so ausgebildet, dass das es eine Gestalt aufweist, die zur Gestalt des zu prüfenden Gegenstands (z.B. der zu prüfenden Batteriezelle) komplementär ist und die PTFE Folie an die Isolierschicht des zu prüfenden Gegenstands gedrückt wird. Diese Gestalt des Trägermaterials wird im Folgenden als "Schale" bezeichnet. Eine solche Schale kann beispielsweise durch 3D-Druck hergestellt werden.

Die Schale erstreckt sich vorzugsweise nicht über die Kontakte der Batteriezelle bzw. über die Fläche der Batteriezelle, auf der die Kontakte angeordnet sind.

Die Dicke des Trägermaterials wird vorzugsweise so gewählt, dass es beim Anlegen mechanisch stabil bleibt und es nicht zu einer Verwindung oder Biegung kommt. Die Dicke des Trägermaterials beträgt vorzugsweise von 2 bis 20 mm; insbesondere von 3 bis 15 mm (z.B. etwa 4 oder etwa 10 mm).

Wenn der zu prüfende Gegenstand (z.B. die Batteriezelle) beispielsweise in Form eines Quaders mit zwei breiteren Seitenwänden und zwei schmaleren Seitenwänden, einer oberen Fläche und einer Bodenfläche vorliegt, wird die Schale so ausgebildet, dass sie einen solchen Quader aufnehmen kann.

Wenn es sich bei dem zu prüfenden Gegenstand um eine quaderförmige Batteriezelle mit Kontakten auf der oberen Fläche handelt, wird die Schale vorzugsweise so ausgebildet, dass die Seitenflächen sowie die Bodenfläche des Quaders in der fertigen Vorrichtung zumindest teilweise mit der elektrisch leitfähigen PTFE Folie in Kontakt gebracht werden, nicht jedoch die obere Fläche, auf der die Kontakte angeordnet sind.

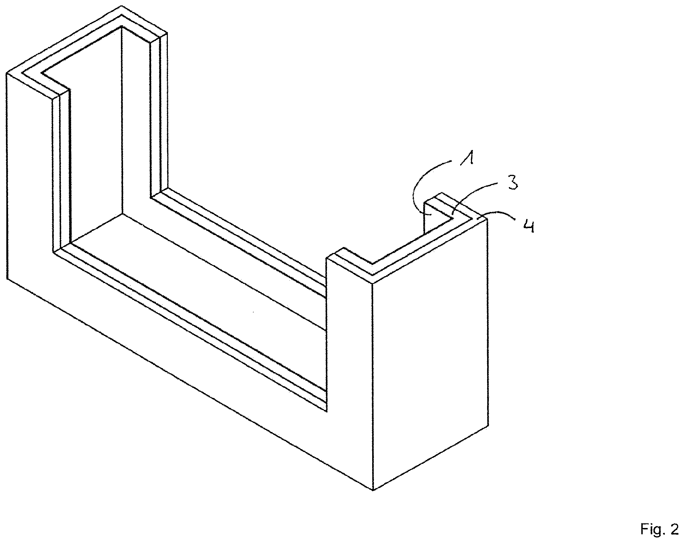

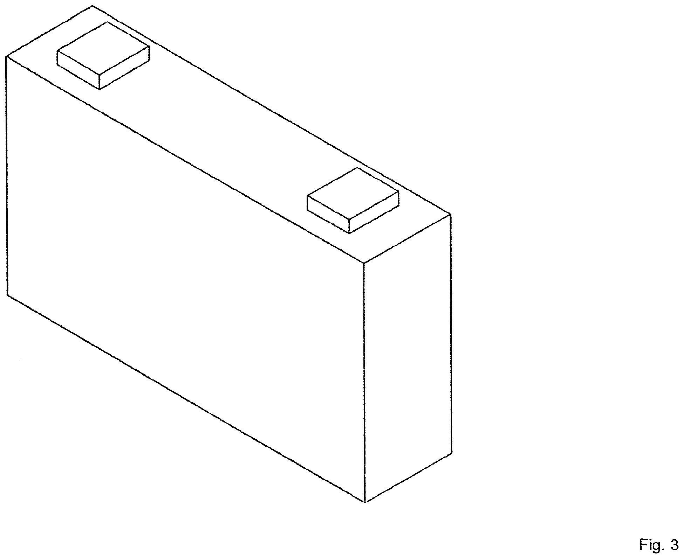

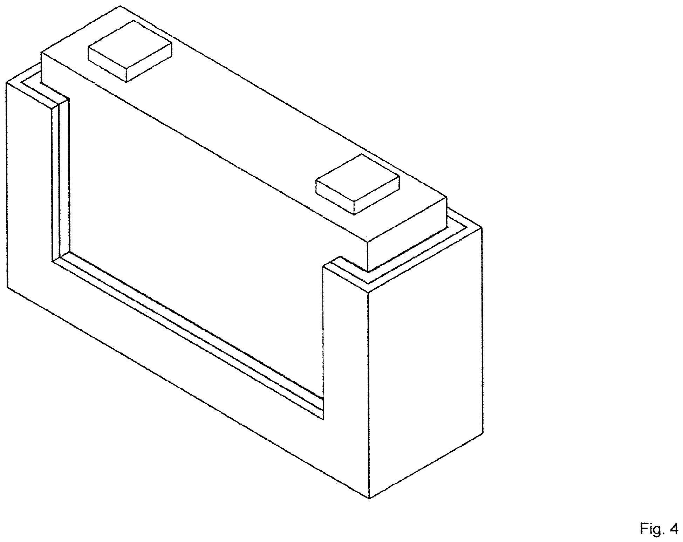

Ein Beispiel für eine bevorzugte Ausführungsform ist in den Figuren 2 bis 4 am Beispiel einer quaderförmigen Batteriezelle gezeigt. In Figur 2 ist eine erfindungsgemäße Vorrichtung mit der entsprechenden Schale aus dem Trägermaterial (4) mit Füllmaterial (3) und leitfähiger PTFE Folie (1) abgebildet. In Figur 3 ist die quaderförmige Batteriezelle schematisch dargestellt. In Figur 4 ist die erfindungsgemäße Vorrichtung aus Figur 2 mit der darin eingebrachten Batteriezelle aus Figur 3 dargestellt. Dabei weist die Schale ein U-förmiges Profil auf, welches wiederum in U-Form dergestalt gebildet ist, dass die Schale die quaderförmige Batteriezelle so aufnehmen kann, dass die Kanten der Batteriezelle, welche die Seitenflächen der Batteriezelle miteinander verbinden, sowie die Kanten der Batteriezelle, welche die Seitenflächen mit der Bodenfläche verbinden, mit der elektrisch leitfähigen PTFE Folie in Kontakt gebracht werden.

Wenn der zu prüfende Gegenstand (z.B. die Batteriezelle) in Form eines Zylinders vorliegt, wird die Schale ebenfalls zylinderförmig ausgeführt, so dass sie den zu prüfenden Gegenstand aufnehmen kann. Wenn bei einer solchen zylinderförmigen Batteriezelle die Kontakte auf der oberen Fläche angeordnet sind, wird die Schale vorzugsweise so ausgebildet, dass sie die Bodenfläche sowie die Mantelfläche umschließt.

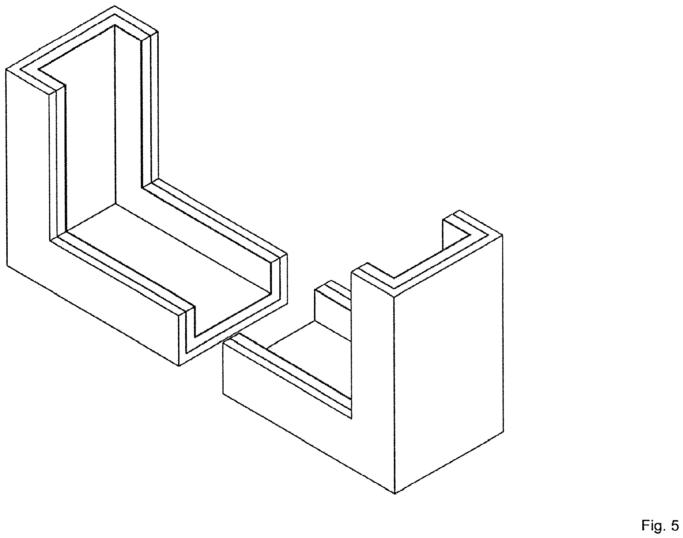

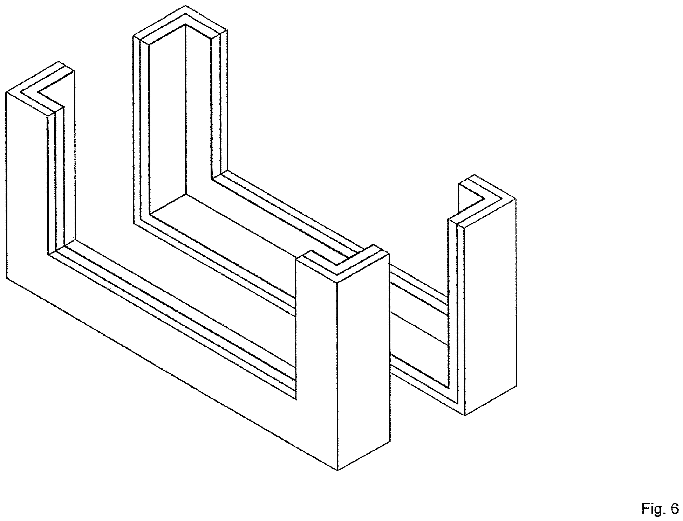

Die erfindungsgemäße Vorrichtung kann gegebenenfalls mehrteilig in Form von Segmenten vorliegen, die relativ zueinander bewegbar sind, um den Raum für die Aufnahme des zu prüfenden Gegenstands (z.B. der Batteriezelle) zu vergrößern. Ein solcher Aufbau bietet den Vorteil, dass die Reibung beim in Kontakt bringen des zu prüfenden Gegenstands mit der erfindungsgemäßen Vorrichtung verringert wird. Vorzugsweise ist die erfindungsgemäße Vorrichtung in zwei oder vier Segmente unterteilt. Beispiele für entsprechende Ausführungsformen der Erfindung sind in den Figuren 5, 6 und 7 gezeigt.

Nachdem die Segmente mit dem zu prüfenden Gegenstand in Kontakt gebracht und zusammengefügt wurden, werden diese mit üblichen Mitteln fixiert. Die Segmente können beispielsweise durch Anpressen mit einem Pneumatikzylinder, mittels Hydraulik oder mit Linearmotoren, oder durch manuelles Anlegen mit dem zu prüfenden Gegenstand in Kontakt gebracht und fixiert werden.

Um die Fugen zwischen den einzelnen Segmenten zu schließen und eine durchgängige Kontaktierung zu gewährleisten, kann die PTFE-Folie bei einem oder mehreren Segmenten überstehen. Dies führt zu einer Überlappung der Folie und damit zu einer geschlossenen Kontaktierung.

Ein Vorteil der Segmentierung in mehrere Teilschalen ist, dass eine Fehlstelle in der Lackschicht der Batteriezelle einem Segment zugeordnet werden kann und somit eine verbesserte Lokalisierung der Fehlstelle stattfinden kann, da es möglich ist, im Fehlerfall mit jedem einzelnen Segment einen separaten HV-Test durchzuführen.

### Ausführungsbeispiel

Es wurde eine Vorrichtung zur Prüfung der Lackschicht von quaderförmigen Batteriezellen hergestellt. Die Außenmaße der hergestellten Vorrichtung betrugen ca. 200 x 70 x 100 mm (L x B x H). Die Vorrichtung hat den in Figur 2 gezeigten Aufbau, d.h. die Schale weist ein U-förmiges Profil auf, welches wiederum in U-Form dergestalt gebildet ist, dass die Schale eine quaderförmige Batteriezelle so aufnehmen kann, dass die Kanten der Zelle, welche die Seitenflächen der Zelle miteinander verbinden, sowie die Kanten der Zelle, welche die Seitenflächen mit der Bodenfläche verbinden, mit der PTFE Folie in Kontakt gebracht werden.

Die Schale ist so dimensioniert, dass die Batteriezelle leicht in der Vorrichtung klemmt. Dabei gibt der Schaum ca. 1 mm nach und drückt die PTFE Folie so an die Lackschicht der Batteriezelle, dass kein Luftspalt entsteht, um eine optimale Kontaktierung zu gewährleisten.

Die Schale aus dem Trägermaterial wurde per 3D-Druck mit dem Schmelzschichtverfahren (FDM/FFF) hergestellt. Die Wandstärke der Schale beträgt 4 mm.

Das Innere der Schale wurde mit einem einseitig selbstklebenden PU-Schaumstoffband mit einer Stärke von 5 mm ausgekleidet.

Auf der Schaumstoffschicht wurde die elektrisch leitfähige PTFE Folie (Dicke: 0.3 mm) mit einem leitfähigen Klebefilm (3M 9713) mit einer Stärke von 0.0889 mm befestigt.

In einer weiteren Ausführungsform wurde die elektrisch leitfähige PTFE Folie (Dicke: 0.3 mm) auf der Schaumstoffschicht mit einem herkömmlichen Kleber befestigt.

Die elektrische Kontaktierung mit einem HV-Testgerät (Stahl DH-110.01 B) erfolgte an einer überstehenden Lasche der PTFE Folie mit Hilfe einer herkömmlichen Schraubverbindung.

Die Funktionsweise der oben beschriebenen Vorrichtungen (mit leitfähigem Klebefilm und mit herkömmlichem Kleber) wurde im Versuch nachgewiesen. Unter realen Prüfbedingungen war es möglich, reale Batteriezellen auf Lackfehlstellen zu überprüfen.

Die PTFE Folie erwies sich in Dauertests (50 x Durchschlag auf die gleiche Stelle sowie 200 x Durchschlag an der gleichen Stelle mit erhöhtem Prüfstrom) bei beiden Vorrichtungen als robust gegenüber Durchschlägen.

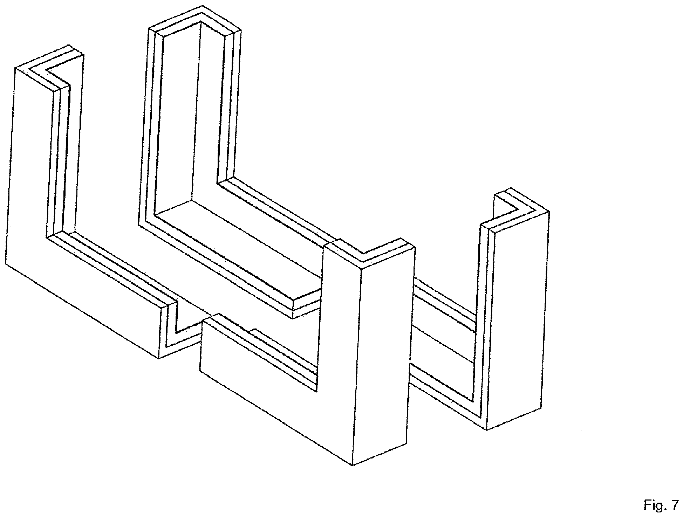

Weiterhin wurde eine Vorrichtung hergestellt, die, wie in Figur 7 gezeigt, in vier Teilschalen segmentiert ist. Diese wird auf die vier zu prüfenden Ecken der Batteriezelle gedrückt. Mit einem Überstand der PTFE Folie von wenigen mm wird durch Überlappung der Folie garantiert, dass eine durchgehende Kontaktierung erfolgt.

Ein Vorteil der Segmentierung in vier Teilschalen ist dabei, dass eine Fehlstelle in der Lackschicht der Batteriezelle einem Segment zugeordnet werden kann und somit eine verbesserte Lokalisierung der Fehlstelle stattfinden kann, da es möglich ist, im Fehlerfall mit jedem einzelnen Segment einen separaten HV-Test durchzuführen.

## Patentansprüche

1. Vorrichtung zur Prüfung einer Isolationsschicht, **dadurch gekennzeichnet, dass** sie eine elektrisch leitfähige PTFE Folie umfasst.

2. Vorrichtung nach Anspruch 1, **dadurch gekennzeichnet, dass** die elektrisch leitfähige PTFE Folie auf einem Füllmaterial aufgebracht ist, welches wiederum auf einem Trägermaterial aufgebracht ist.

3. Vorrichtung nach Anspruch 2, **dadurch gekennzeichnet, dass** das Füllmaterial ein Schaumstoff ist.

4. Vorrichtung nach Anspruch 1 oder 2, **dadurch gekennzeichnet, dass** die elektrisch leitfähige PTFE Folie mit einem elektrisch leitfähigen Klebefilm auf dem Füllmaterial aufgebracht ist.

5. Vorrichtung nach einem der vorhergehenden Ansprüche, **dadurch gekennzeichnet, dass** die elektrisch leitfähige PTFE Folie aus reinem, porösem PTFE besteht, das mit einem elektrisch leitfähigen Material modifiziert ist.

6. Vorrichtung nach einem der vorhergehenden Ansprüche, **dadurch gekennzeichnet, dass** sie eine oder mehrere Flächen mit der elektrisch leitfähigen PTFE Folie aufweist.

7. Vorrichtung nach einem der vorhergehenden Ansprüche, **dadurch gekennzeichnet, dass** sie eine Gestalt aufweist, die zur Gestalt des Gegenstandes mit der zu prüfenden Isolationsschicht komplementär ist.

8. Vorrichtung nach einem der vorhergehenden Ansprüche, **dadurch gekennzeichnet, dass** sie eine quaderförmige Gestalt mit einer Bodenfläche und vier Seitenwänden aufweist, wobei die obere Fläche offen ist.

9. Vorrichtung nach einem der vorhergehenden Ansprüche, **dadurch gekennzeichnet, dass** sie ein U-förmiges Profil aufweist, welches wiederum in U-Form dergestalt gebildet ist, dass die Vorrichtung eine quaderförmige Batteriezelle mit Kontakten auf der oberen Fläche so aufnehmen kann, dass die Kanten der Batteriezelle, welche die Seitenflächen der Batteriezelle miteinander verbinden, sowie die Kanten der Batteriezelle, welche die Seitenflächen mit der Bodenfläche verbinden, mit der elektrisch leitfähigen PTFE Folie in Kontakt gebracht werden.

10. Vorrichtung nach einem der vorhergehenden Ansprüche, **dadurch gekennzeichnet, dass** sie in Form von Segmenten vorliegt, die relativ zueinander bewegbar sind.

11. Verfahren zur Prüfung einer Isolationsschicht durch Anlegen einer Hochspannung, **dadurch gekennzeichnet, dass** eine Vorrichtung nach einem der Ansprüche 1 bis 10 verwendet wird.

12. Verfahren nach Anspruch 11 zur Prüfung einer Isolationsschicht einer Batteriezelle mit metallischem Gehäuse.

13. Verwendung einer elektrisch leitfähigen PTFE Folie zur Prüfung einer Isolationsschicht.
